# EUROPÄISCHE PATENTSCHRIFT

(11) **EP 1 114 465 B1**
(45) Veröffentlichungstag und Bekanntmachung des Hinweises auf die Patenterteilung: **21.03.2007**
(21) Anmeldenummer: 99953550.3
(22) Anmeldetag: 20.08.1999
(51) Int. Cl.: H01L 29/45

(54) **HALBLEITERVORRICHTUNG MIT OHMSCHER KONTAKTIERUNG UND VERFAHREN ZUR OHMSCHEN KONTAKTIERUNG EINER HALBLEITERVORRICHTUNG**
SEMICONDUCTOR DEVICE HAVING OHMIC CONTACT AND A METHOD FOR PROVIDING OHMIC CONTACT WITH SUCH A DEVICE
DISPOSITIF A SEMICONDUCTEUR A CONTACT OHMIQUE ET PROCEDE POUR ETABLIR UN CONTACT OHMIQUE AVEC UN TEL DISPOSITIF

(30) Priorität: 02.09.1998 DE 19839969; 30.04.1999 DE 19919905
(43) Veröffentlichungstag der Anmeldung: 11.07.2001
(73) Patentinhaber: SiCED Electronics Development GmbH & Co KG, 91052 Erlangen (DE)
(72) Erfinder: BARTSCH, Wolfgang, D-91054 Erlangen (DE); SCHÖRNER, Reinhold, D-91091 Gro enseebach (DE); STEPHANI, Dietrich, D-91088 Bubenreuth (DE)
(74) Vertreter: Berg, Peter
(86) Internationale Anmeldenummer: PCT/DE1999/002616
(87) Internationale Veröffentlichungsnummer: WO 2000/014805

(56) Entgegenhaltungen:
- US-A- 3 510 733
- US-A- 5 502 003
- PORTER L M ET AL: "A CRITICAL REVIEW OF OHMIC AND RECTIFYING CONTACTS FOR SILICON CARBIDE" MATERIALS SCIENCE AND ENGINEERING B,CH,ELSEVIER SEQUOIA, LAUSANNE, Bd. B34, Nr. 2/03, 1. November 1995 (1995-11-01), Seiten 83-105, XP000627607 ISSN: 0921-5107 in der Anmeldung erwähnt

## Beschreibung

Die Erfindung bezieht sich auf eine Halbleitervorrichtung mit ohmscher Kontaktierung sowie auf ein Verfahren zur ohmschen Kontaktierung einer Halbleitervorrichtung.

Die Erfindung betrifft insbesondere eine Halbleitervorrichtung, die zumindest in einem Halbleitergebiet, das kontaktiert wird, aus Siliciumcarbid (SiC) besteht.

Siliciumcarbid in einkristalliner Form ist ein Halbleitermaterial mit hervorragenden physikalischen Eigenschaften. Aufgrund seiner hohen Durchbruchfeldstärke ist SiC unter anderem besonders für die Leistungselektronik auch bei Anwendungen im kV-Bereich ein interessantes Halbleitermaterial. Wegen des großen Bandabstands, der auch eine Emission oder Detektion von kurzwelligem Licht im blauen oder ultravioletten Spektralbereich ermöglicht, stellt SiC auch für die Optoelektronik ein vielversprechendes Halbleitermaterial dar.

Da die kommerzielle Verfügbarkeit von Wafern aus einkristallinem Siliciumcarbid insbesondere des 6H- und 4H-Polytyps und auch die technologische Beherrschung von SiC gestiegen ist, finden nun auch SiC-Bauelemente zunehmend Beachtung. So ist z.B. bereits eine Schottky-Diode, eine pn-Diode, verschiedene Transistoren wie ein MOSFET (Metal Oxide Semiconductor Field Effect Transistor), ein MESFET (Metal Semiconductor Field Effect Transistor), oder ein JFET (Junction Field

Effect Transistor) aber auch eine LED (Light Emitting Diode), eine Laserdiode oder ein Photodetektor jeweils auf Siliciumcarbidbasis beschrieben worden.

Für die Funktion dieser Bauelemente wird jeweils zumindest ein stabiler ohmscher Kontakt auf einem Halbleitergebiet aus SiC benötigt. Dieser mindestens eine ohmsche Kontakt befindet sich z.B. auf einer Rückseite des Wafers. Dabei strebt man einen möglichst niedrigen Kontaktwiderstand bei möglichst kleiner Kontaktfläche an, um unerwünschte Verluste am Übergang Halbleiter-Metall zu vermeiden.

In den Übersichtsaufsätzen *"Ohmic contacts* to *SiC" von G.L. Harris* et *al. aus "Properties of Silicon Carbide" ed*. *by G.L. Harris INSPEC, 1995, Seiten 231-234* und *"A critical review of ohmic and rectifying contacts for silicon carbide" von L.M. Porter* und R.F. *Davis, Materials Science and Engineering, B34, 1995, Seiten 83-105* finden sich Zusammenstellungen von Kontaktierungsverfahren für Siliciumcarbid verschiedenen Poly- und Leitungstyps. Demzufolge ist Nickel bislang am häufigsten als Kontaktwerkstoff für einen ohmschen Kontakt auf n-leitendem SiC verwendet worden. Nach Aufbringen des Nickel-Materials wird üblicherweise ein Temperprozeß zur Formierung des ohmschen Kontakts bei einer Prozeßtemperatur über 900°C durchlaufen. Der niedrigste dokumentierte Kontaktwiderstand für n-leitendes SiC liegt bei 1·10⁻⁶ Ωcm². Bei dieser Ausführungsform wird der Nickel-Kontakt fünf Minuten lang bei 1000°C getempert. Das ohmsch kontaktierte Substrat besteht allerdings aus n-leitendem 6H-SiC mit einer wenig praktikablen, hohen Dotierstoffkonzentration von 4,5·10²⁰ cm⁻³. Der Nikkel-Kontakt befindet sich auf der (0001)-Fläche, d.h. auf der Kohlenstoff-Fläche, des 6H-SiC-Substrats.

In der *US 3,510,733* wird ein ohmscher Kontakt zwischen einem Zuleitungsdraht und einem Halbleitergebiet aus n-leitendem Siliciumcarbid beschrieben. Der Zuleitungsdraht besteht dabei entweder aus reinem Chrom oder aus 20 % Chrom und 80 % Nickel oder aus 15 % Chrom, 60 % Nickel und 25 % Eisen oder aus rostfreiem Stahl mit einem Materialanteil von 11 bis 20 % Chrom, bis zu 12 % Nickel, bis zu 2 % Magnesium, bis zu 1 % Silicium, bis zu 0,3 % Kohlenstoff und mit einem Hauptanteil Eisen. Die Hauptforderung an das Material des Zuleitungsdrahts und des ohmschen Kontakts ist dabei eine ausreichende Duktilität und eine Resistenz gegen Oxidation auch bei einer hohen Temperatur. Durch Verbinden der Querschnittsfläche des Zuleitungsdrahts mit dem Halbleitergebiet entsteht ein punktförmiger Kontakt, der insbesondere durch die Drahtgeometrie, wie z.B. Durchmesser, begrenzt ist. Die verwendeten Zuleitungsdrähte haben einen Durchmesser von 0,0508 mm und 0,127 mm. Die ohmsche Verbindung zwischen dem Zuleitungsdraht und dem Halbleitergebiet aus Siliciumcarbid wird durch ein Erhitzen über den Schmelzpunkt der verwendeten Materialien erreicht. Diese Temperaturen liegen zwischen 1500 und 1900°C. Die Prozeßbedingungen bei der Herstellung einer Halbleitervorrichtung aus Siliciumcarbid limitieren eine maximal zulässige Prozeßtemperatur zur Erreichung eines ohmschen Kontakts häufig jedoch auf einen deutlich niedrigeren Wert.

Es ist Aufgabe der Erfindung, eine Halbleitervorrichtung sowie ein Verfahren der eingangs bezeichneten Art mit einer im Vergleich zum Stand der Technik verbesserten Kontaktierung von n-leitendem SiC anzugeben. Dabei soll insbesondere der Kontakt auf dem Halbleitergebiet beim Temperprozeß auf eine niedrigere Prozeßtemperatur als beim Stand der Technik erhitzt werden, wobei aber trotzdem mindestens ein dem Stand der Technik vergleichbarer Kontaktwiderstand erreichbar sein soll.

Die das Erzeugnis betreffende Aufgabe wird durch eine Halbleitervorrichtung mit den in Patentanspruch 1 angegebenen Merkmalen, die die Herstellung eines ohmschen Kontaktes betreffende Aufgabe durch ein die Merkmale des Patentanspruchs 9 aufweisendes Verfahren gelöst.

Die Erfindung beruht dabei auf der Erkenntnis, daß ein stabiler ohmscher Kontakt zu einem Halbleitergebiet aus n-leitendem Siliciumcarbid mit sehr niedrigem Kontaktwiderstand aus einem Material, das aus zwei Materialkomponenten besteht, hergestellt werden kann, wenn die eine Materialkomponente mit dem Silicium des Siliciumcarbids ein Silicid und die andere Materialkomponente mit dem Kohlenstoff des Siliciumcarbids ein Carbid bildet. In dem Übergangsbereich, der sich sowohl in das Halbleitergebiet als auch in die ohmsche Kontaktschicht erstreckt, liegt somit ein quarternäres Materialsystem vor, das aus dem Silicium und dem Kohlenstoff des Siliciumcarbids sowie den beiden Materialkomponenten besteht. Nach einer Auftrennung der atomaren Verbindung zwischen dem Silicium und dem Kohlenstoff des Siliciumcarbids bei einer erhöhten Temperatur ist somit für beide Elemente jeweils ein neuer Verbindungspartner verfügbar, mit dem ein Silicid bzw. ein Carbid gebildet werden kann.

Diese Silicid- und die Carbid-Bildung findet im wesentlichen während des nach dem Materialauftrag durchgeführten Temperprozesses statt. Es kann jedoch auch schon bereits während des Materialauftrags in Abhängigkeit von den herrschenden Prozeßbedingungen (Abscheidetemperatur, Energiegehalt von durch Sputtern erzeugten Materialpartikeln) an der Grenzfläche zum SiC zu einer ersten Keimbildung für das Silicid und das Carbid kommen.

Bei einem reinen Nickel-Kontakt gemäß dem Stand der Technik kommt es während des Temperprozesses ebenfalls zu einer Nikkelsilicid-Bildung. Allerdings bleiben dann aufgrund des stöchiometrischen Verhältnisses zwischen Silicium und Kohlenstoff im Siliciumcarbid Kohlenstoff-Atome in dem Übergangsbereich zurück. Diese bilden dann Graphiteinlagerungen mit einer schlechteren Leitfähigkeit. Dadurch resultiert ein ungünstiger Einfluß auf das ohmsche Kontaktverhalten. Gemäß der Erfindung wird dies verbessert, indem den Kohlenstoff-Atomen ebenfalls ein Verbindungspartner für die Bildung eines Carbids zur Verfügung gestellt wird.

Da die Silicid- und die Carbid-Bildung im wesentlichen während des Temperprozesses stattfinden ist es günstig, wenn sich sowohl die erste als auch die zweite Materialkomponente bereits vor Beginn des Temperprozesses in ausreichendem Umfang an der Grenzfläche zum Halbleitergebiet befinden. Dies wird dadurch erreicht, daß beide Materialkomponenten gleichzeitig aufgebracht werden. Das Material kann dabei in Form eines Gemisches, eines Gemenges, einer Legierung oder einer Verbindung dieser beiden Materialkomponenten als praktisch homogene Schicht auf dem Halbleitergebiet vorliegen. Das Silicid und das Carbid können dann zu jedem Zeitpunkt des Temperprozesses, insbesondere auch gleich nach dem Beginn des Temperns, gebildet werden.

Dabei sind die beiden Materialkomponenten so gewählt, daß sich das Silicid und das Carbid während des Temperprozesses bei einer maximalen Prozeßtemperatur von höchstens 1000°C bilden. Mit dieser Prozeßtemperatur kann dann typischerweise ein Kontaktwiderstand in der Größenordnung von 1.10⁻⁷Ωcm² erreicht werden. Damit wird der beste im Stand der Technik genannte Kontaktwiderstand um etwa eine Größenordnung verbessert.

Nach dem Temperprozeß wird innerhalb der Kontaktschicht eine geringfügig inhomogene Materialzusammensetzung vorliegen. Dies rührt von Austauschvorgängen zwischen den einzelnen Materialkomponenten in dem Übergangsbereich. Durch die Silicid- und Carbid-Bildung kommt es hier nämlich zu einem Austausch von Atomen, die ursprünglich dem Halbleitergebiet und der zunächst praktisch homogen aufgebrachten ohmschen Kontaktschicht zugeordnet waren. Nach Abschluß des Temperprozesses weicht die ohmsche Kontaktschicht somit in dem Übergangsbereich je nach gewählter Verfahrensführung von der im übrigen Bereich der ohmschen Kontaktschicht vorliegenden homogenen Materialzusammensetzung ab. Der Ausdruck "weitgehend homogene ohmsche Kontaktschicht" ist deshalb dann so zu verstehen, daß diese Inhomogenität noch mit umfaßt ist.

Außerdem werden Unterschiede in der Materialzusammensetzung, die auf einer üblichen Verunreinigung in Ausgangssubstanzen zurückzuführen ist, hier ebenfalls als nicht maßgeblich betrachtet.

Die erfindungsgemäße ohmsche Kontaktierung läßt sich mit Vorteil für eine Halbleitervorrichtung aus Siliciumcarbid in verschiedenster Ausprägung einsetzen. Mögliche Ausführungsformen einer SiC-Halbleitervorrichtung sind z.B. eine Schottky-Diode, eine pn-Diode, ein MOSFET, ein MESFET, ein JFET, eine LED, eine Laserdiode oder ein Photodetektor. Weitere Ausführungsformen sind ebenfalls möglich.

Besondere Ausgestaltungen der Halbleitervorrichtung und des Verfahrens nach der Erfindung ergeben sich aus den jeweils abhängigen Unteransprüchen.

In einer bevorzugten Ausführungsform liegt die zweite Materialkomponente mit einem Volumen-Anteil von 2 bis 50 % in dem Material vor. Besonders bevorzugt ist ein Anteil von 10 bis 30 %.

Für die Ausbildung eines guten ohmschen Kontakts ist es vorteilhaft, wenn das n-leitende Halbleitergebiet zumindest an der Grenzfläche zur ohmschen Kontaktschicht eine ausreichend hohe Dotierstoffkonzentration aufweist. Bevorzugt liegt die Dotierstoffkonzentration zwischen 10¹⁷ cm⁻³ und 10²⁰ cm⁻³. Ein besonders guter ohmscher Kontakt ergibt sich bei einer Dotierstoffkonzentration von mindestens 10¹⁹ cm⁻³. Als Dotierstoff kommt in dem n-leitenden Halbleitergebiet Stickstoff oder Phosphor zum Einsatz.

Ein Kontaktwiderstand von höchstens 5.10⁻⁷ Ωcm2 läßt sich in einfacher Weise mit einer Prozeßtemperatur von ca. 900°C erreichen. Bei einer weiter reduzierten Prozeßtemperatur von beispielsweise 850°C erhält man immer noch einen Kontaktwiderstand in der Größenordnung von 1.10⁻⁶ Ωcm².

Erfindungsgemäß besteht die erste Materialkomponente aus Nickel(Ni) oder Kobalt(Co), und die zweite Materialkomponente aus Eisen(Fe), Vanadium(V) oder Tantal(Ta). Diese Materialien sind Silicid- bzw. Carbidbildner. Bevorzugte Materialkombinationen sind Permalloy (NiFe) oder eine Kobalt-Eisen(CoFe)-Legierung.

Bevorzugt hat die ohmsche Kontaktschicht eine Dicke zwischen 15 und 200 nm. Ein so dicker Materialauftrag läßt sich problemlos realisieren. Gleichzeitig wird mit dieser Kontaktschichtdicke sichergestellt, daß eine ausreichende Menge an beiden Materialkomponenten für die Silicid- und Carbidbildung vorhanden ist. Auf diese Weise erhält man eine gute ohmsche Charakteristik des Kontakts. Vorteilhaft ist die Kontaktschicht mindestens so dick, daß die weiteren Bearbeitungsschritte an der Kontaktschicht vorgenommen werden können. Andererseits begrenzen der erforderliche Zeit- und Kostenaufwand die Dicke nach oben. Ein durch Sputtern erfolgter Materialauftrag von 100 nm Dicke dauert hierbei etwa 20 Minuten. Die Kontaktschicht ist außerdem höchstens so dick, daß ein u.U. nachgeschalteter Lift-Off-Prozeßschritt noch ohne besondere Vorkehrungen möglich ist.

Das zu kontaktierende n-leitende Halbleitergebiet kann aus SiC verschiedenen Polytyps bestehen. Es gibt Ausführungsvarianten , bei denen für das n-leitende Halbleitergebiet α-SiC z.B. in Form von 6H-, 4H-, oder 15R-SiC oder β-SiC in Form von 3C-SiC verwendet wird. Andere Polytypen sind jedoch ebenfalls möglich.

Ein α-SiC-Einkristall hat zwei einander gegenüberliegende durch die Kristallgeometrie besonders ausgezeichnete Kristallflächen, die üblicherweise mit (0001)- oder Silicium-Fläche und mit (0001)- oder Kohlenstoff-Fläche bezeichnet werden. Es gibt nun sowohl eine Ausführungsform der Halbleitervorrichtung, bei der die ohmsche Kontaktschicht auf der (0001)-Fläche eines n-leitenden α-SiC-Hlableitergebiets angeordnet ist, als auch eine andere Ausführungsform, bei der sich die ohmsche Kontaktschicht auf der (0001)-Fläche befindet. Die Kontaktschicht aus einer silicid- und einer carbidbildenden Materialkomponente, insbesondere eine Kontaktschicht aus einer Nickel-Eisen-Legierung, hat die besondere Eigenschaft, daß sie im Gegensatz zu der im Stand der Technik u.a. verwendeten reinen Nickel-Kontaktschicht sowohl auf der (0001)-Fläche als auch auf der (0001)-Fläche zu einem gleichermaßen guten Kontaktverhalten führt.

Außerhalb des n-leitenden Halbleitergebiets kann die Halbleitervorrichtung auch zumindest bereichsweise aus einem anderen Material als SiC, beispielsweise aus Silicium (Si) oder Galliumarsenid (GaAs), bestehen. Eine vertikale LED oder Laserdiode kann z.B. auch eine lichtemittierende Galliumnitrid (GaN)-Schichtstruktur auf einem n-leitenden SiC-Substrat umfassen. Auf der der lichtemittierenden GaN-Schichtstruktur abgewandten Seite des SiC-Substrats wird ein ohmscher Kontakt benötigt, über den ein elektrischer Strom in die lichtemittierende Schichtstruktur einspeisbar ist.

In einer weiteren vorteilhaften Ausführungsform der Halbleitervorrichtung befindet sich auf einer von dem n-leitenden SiC-Halbleitergebiet abgewandten Seite der ohmschen Kontaktschicht eine Deckschicht, die insbesondere auch eine Schutzfunktion hat. Sie bedeckt die Kontaktschicht und schützt diese dadurch gegen eine unerwünschte Beeinflussung bei einem ggf. nach der ohmschen Kontaktierung stattfindenden weiteren Prozeßschritt zur Fertigung der Halbleitervorrichtung. So verhindert die Deckschicht z.B. bei einer nachfolgenden Behandlung mit Flußsäure einen direkten Kontakt und damit eine chemische Reaktion der Kontaktschicht mit der Flußsäure.

Die Deckschicht enthält deshalb insbesondere ein metallisches Material, das zudem vorzugsweise chemisch inert gegenüber einer bei einem nachfolgenden Prozeßschritt etwa eingesetzten agressiven Substanz ist. Das verwendete Metall ist außerdem sowohl bei der Prozeßtemperatur des Temperprozesses als auch bei einer Temperatur einer sich anschließenden weiteren Behandlung chemisch und physikalisch praktisch stabil. Bei jeder dieser weiteren Behandlungen liegt die Temperatur immer unterhalb der Prozeßtemperatur des Temperprozesses. Wolfram(W), Tantal(Ta) oder Zirkon(Zr) sind in diesem Zusammenhang beispielsweise geeignete Metalle. Die Deckschicht hat vorzugsweise eine Dicke zwischen 50 und 250 nm. Die Deckschicht hat in diesem Dickenbereich eine ausreichende Dichtheit gegenüber den agressiven Substanzen.

Vorteilhafte Ausführungsformen des Verfahrens, die sich aus den entsprechenden Unteransprüchen ergeben, weisen im wesentlichen die gleichen Vorteile auf wie die obengenannten jeweils korrespondierenden Ausführungsformen der Halbleitervorrichtung selbst.

Andere Ausgestaltungen des Verfahrens beziehen sich auf das Aufbringen des Materials auf das n-leitende Halbleitergebiet und auf den Temperprozeß.

In einer Ausgestaltung des Verfahrens wird das Material, das auf das Halbleitergebiet aufgebracht wird, zwei getrennten Quellen entnommen. Die Quellen enthalten dabei jeweils eine der beiden Materialkomponenten. Die Entnahme erfolgt durch gleichzeitiges Verdampfen oder Zerstäuben (Sputtern). Die Kontaktschicht wird durch Abscheiden der beiden Materialkomponenten auf dem n-leitenden Halbleitergebiet gebildet. Das Material der Kontaktschicht entsteht dabei entweder noch in der Gasphase aus den beiden Materialkomponenten, im Laufe des Abscheidevorgangs oder erst danach. Durch entsprechend eingestellte Prozeßparameter kann gewährleistet werden, daß ein bestimmtes beabsichtigtes Mischungsverhältnis der beiden Materialkomponenten eingehalten wird.

Das Sputtern aus zwei getrennten Quellen kann dabei auch so erfolgen, daß abwechselnd in kurzer zeitlicher Abfolge jeweils nur eine der beiden Materialkomponenten aus der zugehörigen Quelle zerstäubt und als Monoschicht auf dem n-leitenden Halbleitergebiet abgeschieden wird. Die resultierenden Monoschichten sind sehr dünn. Sie haben insbesondere nur eine Dicke in der Größenordnung einiger Ångström. Im Extremfall kann eine solche Monoschicht auch nur aus einer einzigen Atomschicht, einer sog. Monolage, bestehen. Aufgrund der geringen Schichtdicke und der kurzen zeitlichen Abfolge bei der Schichtabscheidung wird auch dieser Materialauftrag der beiden Materialkomponenten hier noch als gleichzeitig bezeichnet. Eine Durchmischung der Atome dieser Monolagen (Homogenisierung) findet dann abhängig von den Prozeßbedingungen zumindest teilweise bereits während des Auftragens selbst oder gleich zu Beginn des sich anschließenden Temperprozesses statt. Aufgrund der geringen Schichtdicke dauert dieser Durchmischungsvorgang nur sehr kurze Zeit.

Bei einer alternativen Ausgestaltung ist es dagegen vorgesehen, zunächst aus der ersten und zweiten Materialkomponente ein Quellmaterial (Legierungstarget) herzustellen und dieses dann in einem zweiten Verfahrensschritt zu zerstäuben. Die so herausgelösten Partikel des Quellmaterials werden dann wie in der vorher beschriebenen Ausgestaltung als Kontaktschicht auf dem n-leitenden SiC-Halbleitergebiet abgeschieden. Ein Verdampfen des Quellmaterials aus der Legierungsquelle ist ebenso möglich.

In einer vorteilhaften Ausführungsvariante wird die Halbleitervorrichtung bei dem Temperprozeß auf eine Prozeßtemperatur von höchstens 900°C, insbesondere auf etwa 850°C, erhitzt. Bevorzugt wird diese Prozeßtemperatur dann für bis zu 2 Stunden, insbesondere für 2 Minuten, etwa konstant gehalten. Bei Bedarf kann der Temperprozeß nämlich auch bei einer niedrigeren Temperatur, wie z.B. bei 800°C, dafür aber über einen längeren Zeitraum, z.B. 30 Minuten lang, durchgeführt werden. Auch eine erheblich längere Temperzeit im Bereich mehrerer Stunden ist möglich. Andererseits kann der Temperprozeß aber auch nur aus einer Aufheizphase und einer unmittelbar folgenden Abkühlphase bestehen, ohne daß dazwischen eine Verweildauer bei einer Prozeßtemperatur vorgesehen wird. Vorzugsweise wird der Aufheiz- und der Abkühlvorgang mit einer sog. RTP(Rapid Thermal Processing)-Anlage oder mit einer sog. RIA(Rapid Isothermal Annealing)-Anlage durchgeführt. Der Temperprozeß dient der ohmschen Formierung der Kontaktschicht. Es zeigt sich, daß nach diesem Temperprozeß auf dem n-leitendem SiC ein temperaturstabiler Kontakt mit guter ohmscher Charakteristik und niedrigem Kontaktwiderstand resultiert.

Günstig ist außerdem eine weitere Ausgestaltung, bei der der Temperprozeß unter Sauerstoffausschluß, insbesondere in einer Inertgasatmosphäre, stattfindet. Ein mögliches Inertgas ist dabei beispielsweise Argon(Ar) oder Helium(He). Aber auch Stickstoff(N) oder Wasserstoff(H) lassen sich zur Erzeugung des Sauerstoffausschlusses vorteilhaft einsetzen. Sauerstoff ist wegen seiner hohen Reaktivität insbesondere mit dem Eisen einer ggf. für die Kontaktschicht verwendeten Nickel-Eisen-Legierung unerwünscht.

Ausführungsbeispiele gemäß der Erfindung werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: eine Halbleitervorrichtung mit einem n-leitenden SiC-Halbleitergebiet und einer angrenzenden Kontaktschicht und
- Figur 2: eine Halbleitervorrichtung in Form eines lateralen Sperrschicht-Feldeffekttransistors mit ohmscher Drain- und Source-Elektrode.

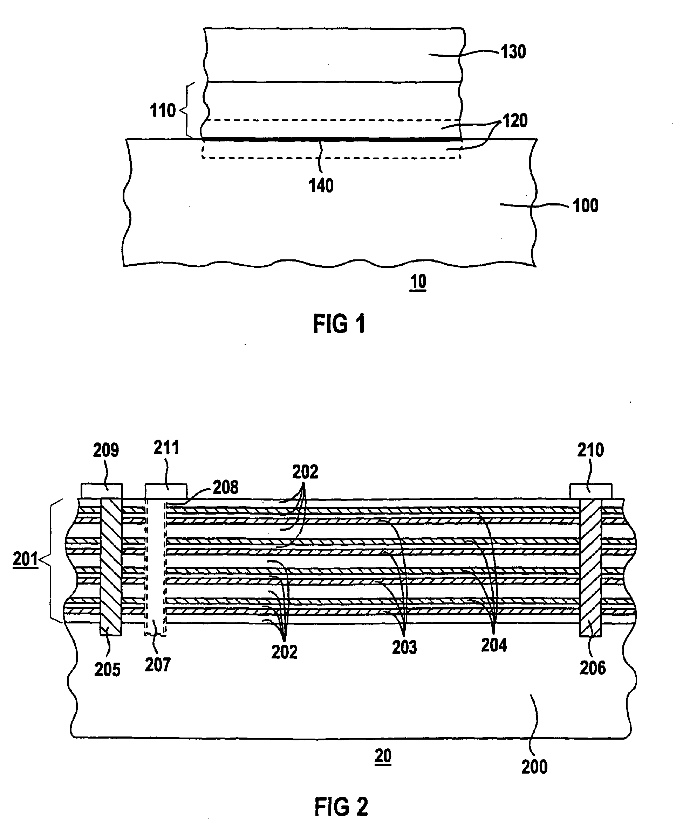

Einander entsprechende Teile sind in den Figuren 1 und 2 mit denselben Bezugszeichen versehen.

Die in Figur 1 gezeigte Halbleitervorrichtung 10 umfaßt ein n-leitendes Halbleitergebiet 100 aus 6H-SiC, auf dessen (0001)-Fläche eine ohmsche Kontaktschicht 110 angeordnet ist. Der in Figur 1 gezeigte Ausschnitt der Halbleitervorrichtung 10 kann dabei Teil eines größeren Bauelements beispielsweise in Form einer pn-Diode, einer Schottky-Diode, einer LaserDiode oder einer LED sein. In jedem Fall ist ein ohmscher Kontakt zu dem n-leitenden SiC-Halbleitergebiet 100 notwendig. Insbesondere können sich an den dargestellten Ausschnitt der Halbleitervorrichtung 10 auch weitere Halbleitergebiete mit anderem Leitungstyp und/oder anderer Dotierstoffkonzentration anschließen.

Das dargestellte n-leitende Halbleitergebiet 100 ist mit einem hohen Anteil an Donatoren, im vorliegenden Fall mit Stickstoff, dotiert. Die Dotierstoffkonzentration liegt bei etwa 5.10¹⁹ cm⁻³. Dadurch wird die Ausbildung eines guten ohmschen Kontakts auf dem Halbleitergebiet 100 begünstigt.

Die Kontaktschicht 110 besteht aus einem Material mit einer ersten und einer zweiten Materialkomponente. Die erste Materialkomponente ist hier Nickel, die zweite Eisen. Das Material der ohmschen Kontaktschicht 110 stellt insbesondere eine unter dem Namen Permalloy bekannte Legierung dar. Der Volumen-Anteil des Nickels beträgt dabei 82 %, der des Eisens 18 %.

Zur ohmschen Kontaktierung des n-leitenden Halbleitergebiets 100 ist eine Permalloy-Legierung besonders vorteilhaft, da das Nickel der ohmschen Kontaktschicht 110 mit dem Silicium des Halbleitergebiets 100 ein Nickelsilicid und das Eisen der ohmschen Kontaktschicht 110 mit dem Kohlenstoff des Halbleitergebiets 100 ein Eisencarbid bilden kann. Die Silicid- und Carbidbildung finden dabei insbesondere in einem Übergangsbereich 120, der sich in das Halbleitergebiet 100 und die ohmsche Kontaktschicht 110 erstreckt, statt.

Wäre dagegen eine Carbidbildung mit der zweiten Materialkomponente nicht möglich, so würde dies bei einer trotzdem auftretenden Nickelsilicidbildung zu einem größeren Anteil graphitisierten Kohlenstoffs in dem Übergangsbereich 120 führen. Der graphitisierte Kohlenstoff bildet z.B. ungeordnete Einlagerungen in dem Übergangsbereich 120, die wegen des Graphits eine verhältnismäßig schlechte Leitfähigkeit haben. Viele derartige Graphiteinlagerungen bewirken somit ein insgesamt ungünstigeres ohmsches Kontaktverhalten. Deshalb ist es erforderlich, daß wie bei der betrachteten Halbleitervorrichtung 10 auch die zweite Materialkomponente und der Kohlenstoff ein Carbid bilden und die Graphitisierung somit zumindest reduziert wird.

Das Material der ohmschen Kontaktschicht 110 wird zunächst durch Sputtern (Zerstäuben) aus einer nicht dargestellten FeNi-Quelle (Legierungstarget) auf das Halbleitergebiet 100 aufgetragen. Aus der FeNi-Quelle herausgelöste FeNi-Materialpartikel werden dazu auf dem Halbleitergebiet 100 abgeschieden. An einer Grenzfläche 140 zum Halbleitergebiet 100 liegen dann sowohl Nickel- als auch Eisen-Atome entsprechend dem gewählten Mischungsverhältnis des Permalloys im Legierungstarget vor. Die so aufgebrachte Kontaktschicht 110 hat eine praktisch homogene Materialzusammensetzung über die gesamte Schichtdicke hinweg.

Nach Aufbringen der Permalloy-Schicht auf das Halbleitergebiet 100 liegt an der Grenzfläche 140 zum Halbleitergebiet 100 also ein quarternäres Materialsystem vor, bei dem jeder der beiden Materialkomponenten der Permalloy-Schicht ein Element des Halbleitergebiets 100 als potentieller neuer Verbindungspartner während eines folgenden Temperprozesses zugeordnet ist.

Zum Schutz gegen den Einfluß einer Prozeßatmosphäre in einem dem Kontaktierungsprozeß nachgeschalteten Bearbeitungsvorgang ist auf der ohmschen Kontaktschicht 110 eine Deckschicht 130 angeordnet. Die Deckschicht 130 bietet aber ggf. auch schon beim Temperprozeß Schutz gegen ein unerwünschtes Einwirken von Sauerstoff auf die ohmschen Kontaktschicht 110, falls die üblicherweise verwendete Inertgasatmosphäre keinen hundertprozentigen Sauerstoffausschluß gewährleisten sollte. Die Deckschicht 130 besteht dabei aus hochschmelzendem und gegenüber den üblicherweise vorliegenden Prozeßgasen chemisch inertem Wolfram. Die Kontaktschicht 110 und die Deckschicht 130 haben jeweils eine Schichtdicke von etwa 100 nm. Die Kontaktschicht 110 und das Halbleitergebiet 100 bilden einen Flächenkontakt mit Abmessungen von bis zu einigen Quadratzentimetern. Bei Bedarf kann jedoch auch eine komplette Waferoberfläche ohmsch kontaktiert werden.

Nach dem Aufbringen der ohmschen Kontaktschicht 110 und der Deckschicht 130 wird die Halbleitervorrichtung 10 zur Formierung des ohmschen Kontakts einem ca. 2minütigen Temperprozeß bei etwa 850°C unterzogen. Während dieses Temperprozesses bilden sich in dem Übergangsbereich 120 das Nickelsilicid und das Eisencarbid. Es ergibt sich zwischen dem n-leitenden Halbleitergebiet 100 und der Kontaktschicht 110 ein Kontaktwiderstand von etwa 1.10⁻⁶ Ωcm². Erfolgt der Temperprozeß bei einer Prozeßtemperatur von etwa 1000°C, so kann damit ein Kontaktwiderstand von 1.10⁻⁷ Ωcm² erreicht werden.

Durch die Silicid- und Carbidbildung entsteht beim Tempern in dem Übergangsbereich 120 eine geringfügig andere Materialzusammensetzung als im übrigen Bereich der Kontaktschicht 110, in dem die ursprünglich vorhandene Homogenität auch nach dem Tempern erhalten bleibt.

In Figur 2 ist eine Halbleitervorrichtung in Form eines Sperrschicht-Feldeffekttransistors (JFET) 20 aus α-Siliciumcarbid dargestellt. Der Sperrschicht-Feldeffekttransistor 20 umfaßt einen SiC-Grundkörper 200 und eine darauf aufgebrachte SiC-Epitaxiestruktur 201. Die Epitaxiestruktur 201 ist dabei in der Weise erzeugt, daß auf dem SiC-Grundkörper 200 abwechselnd epitaktisch undotierte oder nur schwach dotierte Schichten 202 sowie p- oder n-leitende Schichten 203 bzw. 204 aufgetragen werden. Die p-leitende Schicht 203 und die n-leitende Schicht 204 sind paarweise innerhalb der Epitaxiestruktur 201 eingebettet. Sie werden über eine Ionenimplantation mit Bor und/oder Aluminium für die p-leitenden Schichten 203 und mit Stickstoff für die n-leitenden Schichten 204 hergestellt.

In die Epitaxiestruktur 201 werden schmale Gräben für ein Source-Kontaktgebiet 205, ein Drain-Kontaktgebiet 206 und ein Gate-Kontaktgebiet 207 mindestens bis zu dem SiC-Grundkörper 200 geätzt. Diese Gräben werden mit n⁺-dotiertem Siliciumcarbid für das Source-Kontaktgebiet 205 und das Drain-Kontaktgebiet 206 gefüllt. Der Graben für das Gate-Kontaktgebiet 207 wird zunächst an seiner Wand mit einer Isolierschicht 208 versehen. Dies kann durch thermische Oxidation geschehen. Danach wird sein Innenraum mit p⁺-dotiertem Siliciumcarbid aufgefüllt. Das Auffüllen der Gräben kann dabei epitaktisch erfolgen. Das in die Gräben gefüllte n⁺ und p⁺-dotierte Siliciumcarbid wird bis zur obersten undotierten SiC-Schichten 202 der Epitaxiestruktur 201 zurückgeätzt oder abpoliert. Nach Auftragen einer Source-Elektrode 209, einer Drain-Elektrode 210 und einer Gate-Elektrode 211 liegt schließlich der in Figur 2 gezeigte SiC-Sperrschicht-Feldeffekttransistor vor.

Die Source-Elektrode 209 und die Drain-Elektrode 210 bestehen aus einer durch Sputtern oder Aufdampfen aufgetragenen Schicht aus Permalloy (NiFe). Für die Gate-Elektrode 211 wird in bevorzugter Weise eine Ni-Al-Legierung aufgebracht. Diese Metallisierungen werden bei etwa 980°C zur Formierung eines ohmschen Kontakts getempert.

## Patentansprüche

1. Halbleitervorrichtung mit ohmscher Kontaktierung, aufweisend,
- ein Halbleitergebiet (100) aus n-leitendem Siliciumcarbid,
- eine auf dem Halbleitergebiet (100) angeordnete, weitgehend homogene, ohmsche Kontaktschicht (110), wobei die ohmsche Kontaktschicht (110) aus Nickel oder Kobalt als erster Materialkomponente und Eisen, Vanadium oder Tantal als zweiter Materialkomponente besteht, und
- ein sich in das Halbleitergebiet (100) und die ohmsche Kontaktschicht (110) erstreckender Übergangsbereich (120), der sowohl ein aus der ersten Materialkomponente und dem Silicium des Siliciumcarbids gebildetes Silicid als auch ein aus der zweiten Materialkomponente und dem Kohlenstoff des Siliciumcarbids gebildetes Carbid enthält.

2. Halbleitervorrichtung nach Anspruch 1,
**dadurch gekennzeichnet, dass** der Volumenanteil der zweiten Materialkomponente im Bereich von 2% bis 50% oder im Bereich von 10% bis 30% liegt.

3. Halbleitervorrichtung nach einem der vorhergehenden Ansprüche, **dadurch gekennzeichnet,**
**dass** das Halbleitergebiet (100) aus n-leitendem α-Siliciumcarbid besteht und die ohmsche Kontaktschicht (110) auf einer Silicium- oder einer Kohlenstoff-Fläche des α-Siliciumcarbids angeordnet ist.

4. Halbleitervorrichtung nach einem der vorhergehenden Ansprüche, **dadurch gekennzeichnet,**
**dass** das Halbleitergebiet (100) eine Dotierstoffkonzentration zwischen 10¹⁷ cm⁻³ und 10²⁰ cm⁻³ aufweist.

5. Halbleitervorrichtung nach einem der vorhergehenden Ansprüche, **dadurch gekennzeichnet,**
**dass** die ohmsche Kontaktschicht (110) eine Dicke zwischen 15 und 200 nm aufweist.

6. Halbleitervorrichtung nach einem der vorhergehenden Ansprüche, **dadurch gekennzeichnet,**
**dass** auf einer dem Halbleitergebiet (100) abgewandten Seite der ohmschen Kontaktschicht (110) eine Deckschicht (130) angeordnet ist.

7. Halbleitervorrichtung nach Anspruch 6, **dadurch gekennzeichnet, dass** die Deckschicht (130) ein Metall, insbesondere Wolfram, Tantal oder Zirkon, enthält.

8. Halbleitervorrichtung nach Anspruch 6 oder 7, **dadurch gekennzeichnet, dass** die Deckschicht (130) eine Dicke zwischen 50 und 250 nm aufweist.

9. Verfahren zur ohmschen Kontaktierung einer Halbleitervorrichtung, bei dem
- Nickel oder Kobalt als erste Materialkomponente und Eisen, Vanadium oder Tantal als zweite Materialkomponente in Form eines Gemisches, eines Gemenges, einer Legierung oder in Form einer Verbindung auf ein Halbleitergebiet (100) aus n-leitendem Siliciumcarbid gleichzeitig aufgebracht werden,
- eine weitgehend homogene ohmsche Kontaktschicht (110) sowie ein sich in die Kontaktschicht (110) und das Halbleitergebiet (100) erstreckender Übergangsbereich (120) durch Tempern des Halbleitergebiets (100) und der aufgebrachten Materialkomponenten bei einer Prozesstemperatur von höchstens 1000°C erzeugt werden, wobei der Übergangsbereich (120) sowohl ein aus der ersten Materialkomponente und dem Silicium des Siliciumcarbids gebildetes Silicid als auch ein aus der zweiten Materialkomponente und dem Kohlenstoff des Siliciumcarbids gebildetes Carbid enthält.

10. Verfahren nach Anspruch 9, **dadurch gekennzeichnet, dass** as Aufbringen der beiden Materialkomponenten durch Verdampfen oder Sputtern erfolgt.

11. Verfahren nach Anspruch 9 oder 10, **dadurch gekennzeichnet, dass** das Tempern bei einer Prozesstemperatur von höchstens 900°C oder bei einer Prozesstemperatur von etwa 850°C erfolgt.

12. Verfahren nach Anspruch 10 oder 11, **dadurch gekennzeichnet, dass** die Prozesstemperatur für eine Dauer von höchstens 2 Minuten oder für eine Dauer von höchstens 2 Stunden konstant gehalten wird.

13. Verfahren nach einem der Ansprüche 9 bis 12 **dadurch gekennzeichnet, dass** das Tempern unter Sauerstoffausschluss durchgeführt wird.

14. Verfahren nach der vorhergehenden Ansprüche, **dadurch gekennzeichnet, dass** der Volumen-anteil der zweiten Materialkomponente im Bereich von 2% bis 50% oder im Bereich von 10% bis 30% liegt.

15. Verfahren nach einem der vorhergehenden Ansprüche, **dadurch gekennzeichnet, dass** die ohmsche Kontaktschicht (110) vor dem Tempern mit einer metallischen Deckschicht (130) versehen wird.

## Claims

1. Semiconductor device with ohmic contact-connection having
- a semiconductor region (100) made of n-conducting silicon carbide,
- a largely homogeneous ohmic contact layer (110) arranged on the semiconductor region (100) in which case the ohmic contact layer (110) is composed of nickel or cobalt as a first material component and of iron, vanadium or tantalum as a second material component and
- a junction region (120) extending into a semiconductor region (100) and the ohmic contact layer (110) and containing both a silicide formed from the first material component and the silicon of the silicon carbide and a carbide formed from the second material component and the carbon of the silicon carbide.

2. Semiconductor device according to Claim 1, **characterized in that** the proportion by volume of the second material component is in the range of from 2% to 50%, or in the range of from 10% to 30%.

3. Semiconductor device according to one of the preceding claims, **characterized in that** the semiconductor region (100) is composed of n-conducting α-silicon carbide and the ohmic contact layer (110) is arranged on a silicon or a carbon face of the α-silicon carbide.

4. Semiconductor device according to one of the preceding claims, **characterized in that** the semiconductor region (100) has a dopant concentration of between 10¹⁷ cm⁻³ and 10²⁰ cm⁻³.

5. Semiconductor device according to one of the preceding claims, **characterized in that** the ohmic contact layer (110) has a thickness of between 15 and 200 nm.

6. Semiconductor device according to one of the preceding claims, **characterized in that** a covering layer (130) is arranged on a side of the ohmic contact layer (110) which is remote from the semiconductor region (100).

7. Semiconductor device according to Claim 6, **characterized in that** the covering layer (130) contains a metal, in particular tungsten, tantalum or zirconium.

8. Semiconductor device according to Claim 6 or 7, **characterized in that** the covering layer (130) has a thickness of between 50 and 250 nm.

9. Method for ohmic contact-connection of a semiconductor device, in which
- nickel or cobalt as first material component and iron, vanadium or tantalum as second material component are simultaneously applied in the form of a mixture, a batch, an alloy, or in the form of a compound, to a semiconductor region (100) made of n-conducting silicon carbide,
- a largely homogeneous ohmic contact layer (110) and a junction region (120) extending into the contact layer (110) and the semiconductor region (100) are produced by heat treatment of the semiconductor region (100) and the applied material components at a process temperature of at most 1000°C, the junction region (120) containing both a silicide formed from the first material component and the silicon of the silicon carbide and a carbide formed from the second material component and the carbon of the silicon carbide.

10. Method according to Claim 9, **characterized in that** the application of the two material components is effected by vaporization or sputtering.

11. Method according to Claim 9 or 10, **characterized in that** the heat-treatment is effected at a process temperature of at most 900°C, or at a process temperature of about 850°C.

12. Method according to Claim 10 or 11, **characterized in that** the process temperature is kept constant for a duration of at most two or for a duration of at most two hours.

13. Method according to one of Claims 9 to 12, **characterized in that** the heat-treatment is carried out with the exclusion of oxygen.

14. Method according to one of the preceding claims, **characterized in that** the proportion by volume of the second material component is in the range of from 2% to 50%, or in the range of from 10% to 30%.

15. Method according to one of the preceding claims, **characterized in that** the ohmic contact layer (110) is provided with a metallic covering layer (130) before the heat-treatment.

## Revendications

1. Dispositif à semi-conducteur avec réalisation d'un contact ohmique, comportant
- une zone semi-conductrice (100) en carbure de silicium à conductivité de type N,
- une couche de contact ohmique (110) largement homogène située sur la zone semi-conductrice (100),
- la couche de contact ohmique (110) étant composée de nickel ou de cobalt en tant que premier composant du matériau et de fer, de vanadium ou de tantale en tant que deuxième composant du matériau et
- une zone de jonction (120), qui contient non seulement un siliciure formé à partir du premier composant du matériau et du silicium du carbure de silicium, mais aussi un carbure constitué à partir du deuxième composant du matériau et du carbone du carbure de silicium, s'étendant dans la zone semi-conductrice (100) et la zone de contact ohmique (110).

2. Dispositif à semi-conducteur selon la revendication 1, **caractérisé en ce que** la fraction volumique du deuxième composant du matériau est de l'ordre de 2 % à 50 % ou de l'ordre de 10 % à 30 %.

3. Dispositif à semi-conducteur selon l'une des revendications précédentes, **caractérisé en ce que** la zone semi-conductrice (100) est composée de carbure de silicium α à conductivité de type N et la couche de contact ohmique (110) est située sur une face silicium ou une face carbone du carbure de silicium α.

4. Dispositif à semi-conducteur selon l'une des revendications précédentes, **caractérisé en ce que** la zone semi-conductrice (100) présente une concentration de dopant comprise entre 10¹⁷ cm⁻³ et 10²⁰ cm⁻³.

5. Dispositif à semi-conducteur selon l'une des revendications précédentes, **caractérisé en ce que** la couche de contact ohmique (110) présente une épaisseur comprise entre 15 et 200 nm.

6. Dispositif à semi-conducteur selon l'une des revendications précédentes, **caractérisé en ce qu'**une couche de recouvrement (130) est située sur un côté du contact ohmique (110) opposé à la zone semi-conductrice (100).

7. Dispositif à semi-conducteur selon la revendication 6, **caractérisé en ce que** la couche de recouvrement (130) contient un métal, en particulier du tungstène, du tantale ou du zirconium.

8. Dispositif à semi-conducteur selon la revendication 6 ou 7, **caractérisé en ce que** la couche de recouvrement (130) présente une épaisseur comprise entre 50 et 250 nm.

9. Procédé pour établir un contact ohmique avec un dispositif à semi-conducteur, dans lequel
- on applique simultanément du nickel ou du cobalt en tant que premier composant du matériau et du fer, du vanadium ou du tantale en tant que deuxième composant du matériau sous la forme d'une mixture, d'un mélange, d'un alliage ou sous la forme d'un composé sur une zone semi-conductrice (100) en carbure de silicium à conductivité N;
- une couche de contact ohmique (110) largement homogène ainsi qu'une zone de jonction (120) qui s'étend dans la couche de contact (110) et la zone semi-conductrice (100) sont générées par recuit, à une température de process de maximum 1000 °C, de la zone semi-conductrice (100) et des composants du matériau appliqués, la zone de jonction (120) contenant non seulement un siliciure formé à partir du premier composant du matériau et du silicium du carbure de silicium, mais aussi un carbure formé à partir du deuxième composant du matériau et du carbone du carbure de silicium.

10. Procédé selon la revendication 9, **caractérisé en ce que** l'application des deux composants du matériau se fait par vaporisation ou sputtering.

11. Procédé selon la revendication 9 ou 10, **caractérisé en ce que** le recuit se fait à une température de process de maximum 900 °C ou à une température de process de quelque 850 °C.

12. Procédé selon la revendication 10 ou 11, **caractérisé en ce que** la température de process est maintenue constante pour une durée de maximum 2 minutes ou pour une durée de maximum 2 heures.

13. Procédé selon l'une des revendications 9 à 12, **caractérisé en ce que** le recuit est effectué sous vide d'oxygène.

14. Procédé selon l'une des revendications précédentes, **caractérisé en ce que** la fraction volumique du deuxième composant du matériau est de l'ordre de 2 % à 50 % ou de l'ordre de 10 % à 30 %.

15. Procédé selon l'une des revendications précédentes, **caractérisé en ce que** la couche de contact ohmique (110) est pourvue d'une couche de recouvrement métallique (130) avant le recuit.
